# EUROPEAN PATENT APPLICATION

(11) **EP 4 071 791 A1**
(43) Date of publication of application: **12.10.2022**
(21) Application number: 21167670.5
(22) Date of filing: 09.04.2021
(51) Int. Cl.: H01L 23/00

(54) **SPRING ELEMENT FOR A PRESS CONTACT IN A POWER SEMICONDUCTOR MODULE, AND METHOD FOR MANUFACTURING THE SAME**

(71) Applicant: Hitachi Energy Switzerland AG, 5400 Baden (CH)
(72) Inventor: DUGAL, Franc, 8121 Benglen (CH)
(74) Representative: Epping - Hermann - Fischer

(57) **Abstract**

The present disclosure relates to a spring element (110) configured for forming a press contact in a power semiconductor module (200). The spring element (110) comprises a first contact portion (126) having a first contact (110) and a second contact portion (128) having a second contact (118), wherein the spring element (110) is adapted for exerting a spring force (Fₛ) onto the first contact portion (126) and the second contact portion (128). The spring element (110) comprises a core (140) made from a first material and a conductive coating (142) made from a second material, wherein the first material has a higher elasticity than the second material so as to provide a significant part of the spring force (Fₛ) and the second material has a higher electrical conductivity than the first material so as to carry a significant part of a current flowing from the first contact (116) to the second contact (118), or vice versa.

The present disclosure further relates to a power semiconductor module (200) comprising a corresponding spring element (110) and a method for manufacturing a spring element (110) .

## Description

The present disclosure relates to a spring element configured for forming a press contact in a power semiconductor module, the spring element comprising a first contact and a second contact to be pressed against corresponding contact areas. The present disclosure further relates to a power semiconductor module comprising a spring element and a method for manufacturing a spring element.

Document WO 2016/207118 A1 relates to a spring element for a power semiconductor module wherein the spring element comprises a first part made from a first material and a second part made from a second material.

Embodiments of the disclosure relate to an alternative spring element for forming a press contact. For example, there is a need for spring elements that can be manufactured using fewer steps or parts or mounted more easily in a semiconductor power module.

According to a first aspect of the disclosure, a spring element configured for forming a press contact in a power semiconductor module is provided. The spring element comprises a first contact portion having a first contact and a second contact portion having a second contact. The spring element is adapted for exerting a spring force onto the first contact portion and the second contact portion for pressing the first contact to a first contact area of a power semiconductor module and for pressing the second contact to a second contact area of the power semiconductor module. The spring element comprises a core made from a first material and a conductive coating made from a second material, the first material being different from the second material. The core made from the first material has a higher elasticity than the conductive coating made from the second material so as to provide a significant part of the spring force. The conductive coating made from the second material has a higher electrical conductivity than the core made from the first material so as to carry a significant part of a current flowing between the first contact and the second contact. The current may flow from the first contact to the second contact or from the second contact to the first contact.

The use of an elastic spring element comprising an elastic core made from a first material and a conductive coating made from a second material allows for the formation of one-piece spring elements, which are easy to manufacture and mount, for example within a power semiconductor module. For example, it is no longer necessary to assemble the spring element from different parts, which could potentially be separated during assembly or operation of the power semiconductor module.

The first material and/or the second material may be a pure substance, exemplarily a metal, or it may be an alloy, exemplarily a metal alloy or an alloy comprising at least one metal.

According to at least one embodiment, the spring element further comprises a deformation portion for providing the spring force to the first contact portion and the second contact portion, wherein the first contact portion is located opposite to the second contact portion with regard to the deformation portion.

According to at least one embodiment, the deformation portion, the first contact portion and the second contact portion may comprise a bent, elongated strip of metal.

According to different embodiments, the deformation portion may be essentially S-shaped or C-shaped. Such shapes are easily manufactured and are symmetric, resulting in a consistent and equal application of the required spring force to the respective contact areas.

According to at least one embodiment, the spring element further comprises a protective coating from a third material coating at least parts of the conductive coating, the third material being different than the second material. Such a conductive coating may prevent oxidation or similar unwanted chemical processes and can be applied, for example, outside the contact areas.

According to a second aspect of the present disclosure, a power semiconductor module comprising at least one spring element according to the first aspect or one of its embodiments is provided.

In at least one embodiment, the spring element forms part of a control path for controlling the power semiconductor module. For example, the spring element may be used to contact a control gate of a semiconductor switch, such as an IGBT, a MOSFET, a MISFET or another power semiconductor device.

According to at least one embodiment, the spring element has a predefined electrical resistivity and is configured to function as an external gate resistor in the control path. By selecting appropriate materials and an appropriate geometry for the spring element, the spring element can serve as an external gate resistor, eliminating the need for providing a separate resistive element in the control path.

According to a third aspect of the disclosure, a method for manufacturing a spring element comprising a first contact portion, a second contact portion and a deformation portion is provided. The method comprises providing a core from a first material, and providing a conductive coating from a second material on the core to form a conductive path comprising at least one first contact on the first contact portion and at least one second contact on the second contact portion, the first material being different from the second material, forming the core to create the deformation portion for providing a spring force, wherein the first contact portion is located on an opposite side of the second contact portion with regard to the deformation portion, wherein the core has a higher elasticity than the conductive coating so as to provide a significant part of the spring force (FS), and wherein the conductive coating has a higher electrical conductivity than the core so as to carry a significant part of a current flowing between the first contact and the second contact.

The above steps are easy to implement and allow the production of a single part spring element suitable for a power semiconductor module. For example, the above steps allow to manufacture a spring element according to the first aspect by first coating a core made from a first material with a second material, and then shaping the coated core into a spring shape.

According to a fourth aspect of the disclosure, a method for manufacturing a spring element comprising a first contact portion, a second contact portion and a deformation portion is provided. The method comprises providing a core from a first material with a deformation portion for providing a spring force, wherein the first contact portion is located on an opposite side of the second contact portion with regard to the deformation portion, forming a conductive coating from a second material on the core by coating the core with the conductive coating or electroplating the core to form a conductive path comprising at least one first contact on the first contact portion and at least one second contact on the second contact portion, the first material being different from the second material, wherein the core has a higher elasticity than the conductive coating so as to provide a significant part of the spring force, and wherein the conductive coating has a higher electrical conductivity than the core so as to carry a significant part of a current flowing between the first contact and the second contact.

The above steps are easy to implement and allow the production of a single part spring element suitable for a power semiconductor module. The above steps allow to manufacture a spring element according to the first aspect by coating a spring-shaped core made from a first material with a second material. For example, the step of coating the core of the spring element with a coating from the second material may comprise electroplating the core made from a first metal material with a second metal material.

The present disclosure comprises several aspects of an invention. Every feature described with respect to one of the aspects is also disclosed herein with respect to the other aspect, even if the respective feature is not explicitly mentioned in the context of the specific aspect.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.

While the invention is amenable to various modifications and alternative forms, specifics thereof have been shown by way of example in the figures and will be described in detail. It should be understood, however, that the intention is not to limit the invention to the particular embodiments described. On the contrary, the intention is to cover all modifications, equivalents, and alternatives falling within the scope of the invention defined by the appended claims.
Figures 1A to 1D show a spring element according to a first embodiment of the present disclosure.
Figure 1E shows a cross section through a modified version of the spring element of the first embodiment.
Figures 2A and 2B show a spring element according to a further embodiment of the present disclosure.
Figure 3 shows a power semiconductor module according to an embodiment of the present disclosure.
Figure 4 shows a flowchart of a method for manufacturing a spring element according to an embodiment of the disclosure.
Figure 5 shows a spring element according to the prior art.

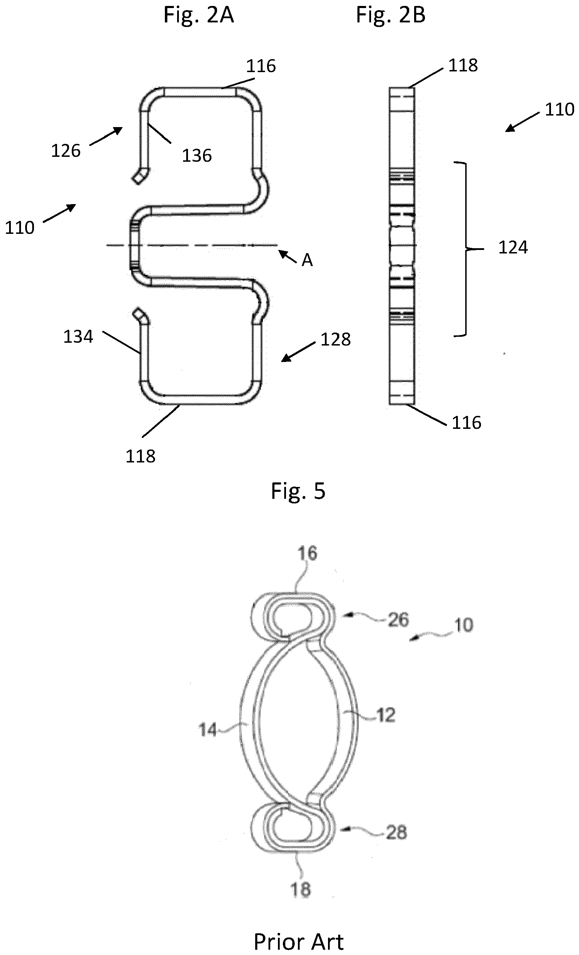

Before the various embodiments of the present disclosure are described in more detail, at first a spring element 10 according to the prior art is described with reference to Figure 5.

The spring element 10 of Figure 5 comprises a first part 12 made from copper and a second part 14 made from steel. Both the first part 12 and the second part 14 are formed as individual one-piece parts and are formed as brackets. The first part 12 comprises both a first contact portion 26 having a first contact 16 and a second contact portion 28 having a second contact 18, wherein the first part 12 comprises an electrically conductive path formed from the first contact portion 26 to the second contact portion 28. The second part 14 is adapted for exerting a spring force onto the first contact portion 26 and the second contact portion 28 for pressing the first contact 16 to a first contact area and the second contact 18 to a second contact area (not shown in Figure 5).

While the spring element 10 shown in Figure 5 provides good elasticity and a good electrical connection between the respective contact areas, due to its two-part assembly it is relatively expensive to manufacture and may also become damaged during transport, assembly or operation of a respective power module. Accordingly, in the following, various embodiments of improved spring elements are disclosed, which are easier to manufacture and mount in a semiconductor power module.

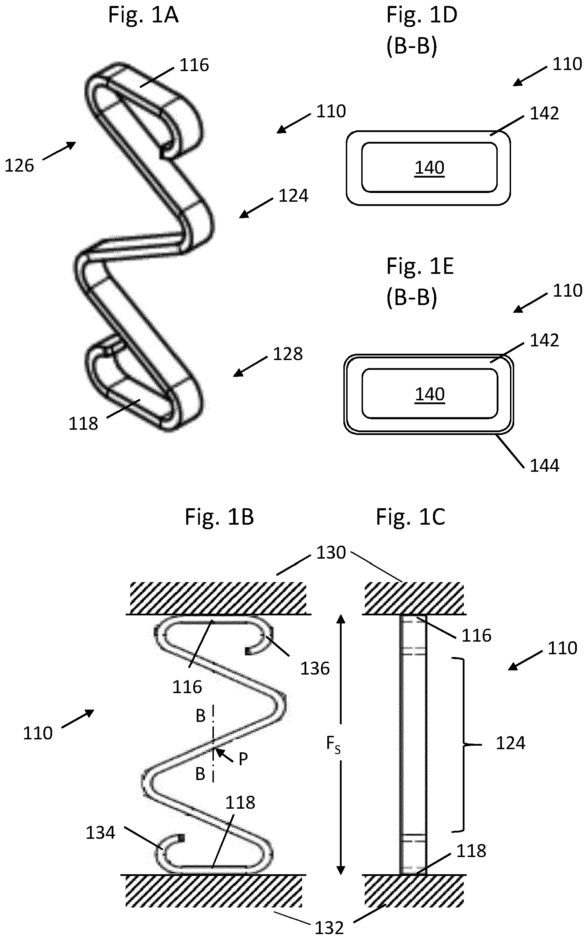

Figures 1A to 1D show a first embodiment of a spring element 110 according to a first embodiment suitable for use in a power semiconductor module.

The spring element 110 according to the first embodiment is formed from an elongated, bent strip of metal material. As can be seen in Figures 1A to 1C, the spring element 110 comprises an upper, first contact portion 126, a lower, second contact portion 128 and a deformation portion 124 connecting the first contact portion 126 and the second contact portion 128. Each one of the first contact portion 126 and the second contact portion 128 comprises an essentially horizontal first contact 116 and second contact 118, respectively. The spring element 110 is designed to provide a desired proper travel distance and spring force F_{S} for assembly of a semiconductor power module as detailed later.

As can be best seen in Figures 1A and 1B, the deformation portion 124 is essentially S-shaped and point symmetric with regard to a central point P. In the mounted position, the deformation portion 124 can be compressed in a vertical direction, thus exerting a spring force F_{S} between the first contact portion 126 and the second contact portion 128. The first contact portion 126 and the second contact portion 128 form essentially the upper and lower part of a semi-circle, or three-quarter circle when including the bent terminal part 134 and 136, respectively. Consequently, the first contact 116 is pressed against a first contact area 130 and a second contact 118 is pressed against a second contact area 132 as shown, for example, in Figures 1B and 1C.

To avoid injuries and simplify insertion of the spring element 110 into a power semiconductor module, each one of the first contact portion 126 and the second contact portion 128 ends in a bent terminal part 134 and 136, respectively.

To achieve both a good mechanical as well as electrical characteristic, the elongated metal strip forming the spring element 110 is made from two materials. This can be best be seen in the cross-section through the center of the metal strip shown in Figure 1D. In the disclosed embodiment, the metal material of the spring element 110 comprises a core 140 made from a first material and a conductive coating 142 made from a second material. In consequence, the separation of the current path and spring capability is still present, but these functions have been combined in one part. In this solution the spring element 110 is not made from one material, but from a combination of two distinct materials. Nonetheless, the two materials are not mixed together, like in an alloy, but stay distinct. Yet, they mechanically form a single piece. Use of a relatively flat core geometry, such as that of the elongated metal strip, provides a relatively large surface area for coating, as detailed below.

In the described example, the core 140 is made from a first metal material having a relatively high elasticity, so as to provide a large portion of the spring force F_{S}. For example, the first material may have an elasticity or spring force being determined by a Young modulus of equal or more than 100 GPa. Such an elasticity results in a high spring force of the spring element, ensuring a good mechanical and electrical contact between the respective contacts 116 and 118 and contact areas 130 and 132. Its thickness can be selected dependent on the required spring force F_{S}.

In the described example, the core 140 is made from spring steel or stainless steel having a thickness of somewhere between 0.2 and 2.5 mm, or 0.5 and 1.0 mm, for example 0.8 mm. It has a width between 0.5 and 30 mm, or 2.0 and 20 mm for example 2 mm, 9 mm or 10 mm, wherein the above-named values are in no way restricting the present disclosure.

In contrast, the conductive coating 142 is made from a second metal material having a higher electric conductivity than the core material. For example, the second material may have an electric conductivity of equal or more than 5.0 x 10⁶ S/m, for example 6.0 x 10⁷ S/m. Such a high electric conductivity results in a good conductive path between the first contact 116 and the second contact 118. Its thickness can be selected dependent on the current level through the spring element 110 for a desired application, e.g. a control path of a semiconductor power module.

In the described example, a gold, silver, copper or aluminum coating having a thickness between 2 and 20 µm, or 5 to 15 µm, for example 10 µm, may be applied to all surfaces of the core 140, wherein the above-named values are in no way restricting the present disclosure. This can be achieved, for example, using electroplating.

Optionally, in another embodiment as shown in Figure IE, the spring element 110 may be further coated with a protective coating 144. In the depicted embodiment, the outside surfaces of the conductive coating 142 of the spring element 110 is coated with the protective coating 144 on all sides. This is useful, for example, to protect a conductive coating 142 made from a non-inert material, such as copper or aluminum, from oxidation. Depending on the materials used and the conductivity desired, the protective coating 144 may be provided on all surfaces of the spring element 110 or only in certain areas. For example, for improved electrical contacts, the contacts 116 and 118 may not comprise a protective coating, whereas the rest of the spring element 110 may be covered with the protective coating 144. For example, a coating with nickel phosphate (NiP), silver or gold may be deposited, for example by electroless plating.

Figures 2A and 2B show an alternative embodiment of a spring element 110. For reasons of simplicity, corresponding reference numerals have been used in its description.

Like the spring elements 110 shown in Figures 1A to 1E, the spring element 110 according to Figures 2A and 2B comprises a first contact portion 126 with a first contact 116, a second contact portion 128 with a second contact 118 and a deformation portion 126 formed there between. Similarly, the spring element 110 of Figures 2A and 2B is made from an elongated metal strip having a core 140 and a protective coating 142 as detailed above.

The further embodiment shown in Figures 2A and 2B differs from the embodiments shown in Figures 1A to 1E in that the deformation portion 126 is essentially C-shaped and therefore axis symmetrical with regard to a central plane or axis A parallel to the first contact area 130 and second contact area 132. Moreover, of the bent terminal parts 134 and 136 are also C-shaped, with their respective opening pointing downwards and upwards, respectively. The ends of the bent terminal parts 134 and 136 are bent outwards with respect to a vertical center line through the spring element 110.

Although not shown in the figures, other spring shapes may also be employed. For example, a spiral spring wound around a central, vertical axis perpendicular to the contact areas 130 and 132 may be used to as a basic form of a spring element 110 (not shown). Due to its typically smaller surface area and greater length, such a spring element is better suited for relatively low currents.

In each of the above embodiments, the core 140 of the spring element provides a significant part of the spring force. For example, more than 50 %, more than 75 %, or more than 90 % of a total force exerted by the spring element 110 to one of the contact areas 130 or 132 is generated by the core 140 itself, i.e. independent from the conductive coating 142.

Likewise, the conductive coating 142 to carries a significant part of a current flowing from the first contact 116 to the second contact 118. For example, more than 50 %, more than 75 %, or more than 90 % of a total current flowing from the first contact 116 through the spring element 110 to the second contact 118 is flowing through the material of the conductive coating, i.e. independent from any electrical current in the core 142.

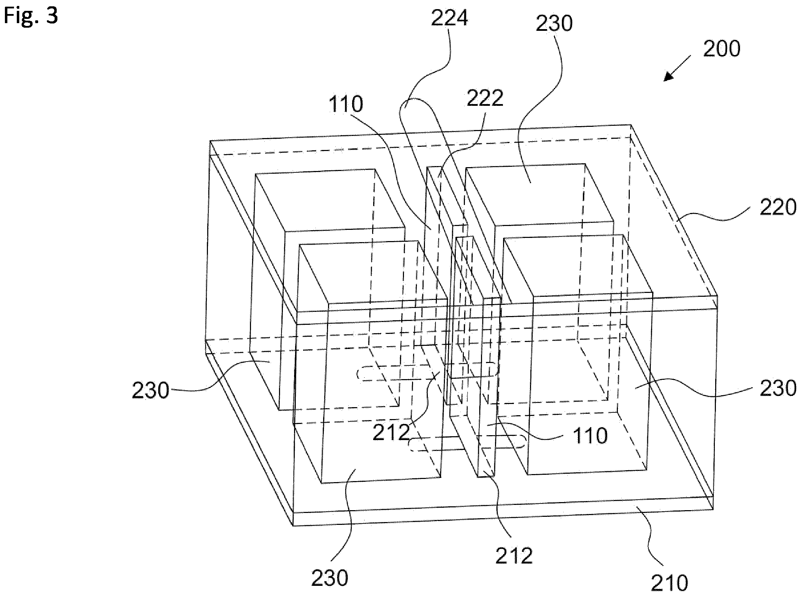

Figure 3 shows, in a schematic manner, a power semiconductor module 200 according to the present disclosure.

In the embodiment shown in Figure 3, the power semiconductor module 200 comprises a baseplate 210, a contact plate 220, a total of four semiconductor elements 230 and two spring elements 110, for example the spring elements 110 according to the embodiments of Figures 1A to 2B described above. Of course, fewer or more semiconductor elements 230 and/or spring elements are also possible. This should not be limited by the described example configuration.

As shown in Figure 3, the semiconductor elements 230 are arranged between the baseplate 210 and the contact plate 220. For example, each semiconductor elements 230 may be a power semiconductor chip, such as an insulated-gate bipolar transistor (IBGT) chip, a metal-oxide-semiconductor field-effect transistor (MOSFET), a metal-insulator-semiconductor field-effect transistor (MISFET) or a bi-mode insulated gate transistor (BIGT), or a similar semiconductor element having at least one control gate. In the described embodiments, all semiconductor elements 230 are electrically connected in parallel to control a relative large load current. For this purpose, the bottom surface of the semiconductor elements 230 contacts a corresponding area of the baseplate 210 providing a common emitter terminal. Moreover, the top surface of the semiconductor elements 230 contacts a corresponding area of the contact plate 230 to providing a common collector terminal.

A central part of the baseplate 210 comprises two first gate contact areas 212. Correspondingly, the contact plate 220 comprises two second gate contact areas 222. The first gate contact areas 212 are electrically connected to corresponding gate contacts of the semiconductor elements 230. To provide an electrical control path from a gate electrode 224 on the contact plate 220, the two spring elements 110 are placed between the first gate contact 212 and the second gate contact 222. Use of the spring elements 110 enables an improved flexibility of the power semiconductor module 200, for example when several of the power semiconductor module 200 are stacked into even larger units.

Attention is drawn to the fact that the current and/or voltage of the control part is typically significantly lower than the current and/or voltage of the load path, for example a control voltage of less than 25 V and/or a control current of less than 50A. However, the electrical resistivity and inductivity of the control path has a strong influence on the switching behavior of the power semiconductor module 200. Provision of the disclosed spring elements 110 with their conductive coating 142 ensures that the control path shows very good electrical conduction.

The spring elements 110 can be tailored with regard to its electrical resistivity. Either the resistivity of the spring element is designed to be as low as possible, e.g. below 1 Q or below 0.1 Q, and does not significantly alter the electrical path to the gate contact. Alternatively, the spring elements 110 may have a predefined electrical resistivity, which is used as external gate resistor for the semiconductor elements 230 of the power semiconductor module 200. For example, the spring elements 110 is tailored to have a resistivity of a fixed value, typically below 10 Ω. This can be achieved, for example, by the specific configuration of the spring elements 110, especially their geometric proportions and choice of materials.

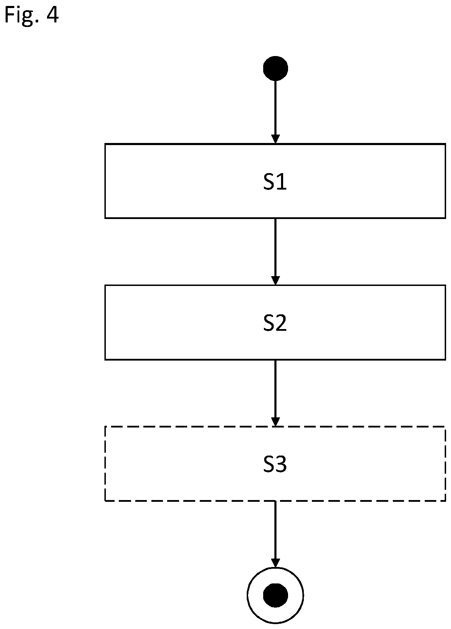

Figure 4 shows a flow chart of a method for manufacturing a spring element 110 comprising steps S1 to S3. Attention is drawn to the fact that the order of the steps shown in Figure 4 may be changed in other embodiments of the method. For example, an elongated metal strip may first be coated with a conductive coating, before it is formed in a specific shape, for example by bending.

In a first step S1, a core 140 of a spring element is formed from a first material. For example, an elongated strip of metal may be bent to form an S or C-shaped deformation portion, respective contact portions 128 and 126 at each end as well as bent terminal parts 134 and 136. The core 140 of the spring element is formed from a material having a relatively high elasticity, such as spring steel.

In a second step S2, the core 140 of the spring element 110 is coated with a second material to form a conductive coating 142. For example, the core 140 of the spring element 110 prepared in step S1 may be electroplated with a second metal material, such as copper, silver, gold or aluminum. For example, a conductive coating 142having a thickness of 10 µm may be formed on all surfaces of a spring steel core 140.

In an optional third step S3, parts or all surfaces of the conductive coating 142 may be further coated with a protective coating 144. For example, a protective layer may be formed in the deformation portion 124.

The embodiments shown in the Figures 1 to 4 as stated represent exemplary embodiments of the improved devices and methods for their manufacture. Therefore, they do not constitute a complete list of all embodiments according to the improved devices and methods. Actual devices and methods may vary from the embodiments shown in terms of their geometrical configuration, material choices and specific processing methods, for example.

### Reference Signs

- 10: spring element
- 12: first part
- 14: second part
- 16: first contact
- 18: second contact
- 26: first contact portion
- 28: second contact portion
- 110: spring element
- 116: first contact
- 118: second contact
- 124: deformation portion
- 126: first contact portion
- 128: second contact portion
- 130: first contact area
- 132: second contact area
- 134: first bent terminal part
- 136: second bent terminal part
- 140: core
- 142: conductive coating
- 144: protective coating
- 200: power semiconductor module
- 210: baseplate
- 212: first gate contact
- 220: contact plate
- 222: second gate contact
- 224: gate contact
- 230: semiconductor element
- A: central axis
- F_{S}: spring force
- P: central point

## Claims

1. A spring element (110) configured for forming a press contact in a power semiconductor module (200), the spring element (110) comprising a first contact portion (126) having a first contact (116) and a second contact portion (128) having a second contact (118); wherein
- the spring element (110) is adapted for exerting a spring force (F_{S}) onto the first contact portion (126) and the second contact portion (128) for pressing the first contact (116) to a first contact area (130) of a power semiconductor module (200) and the second contact (118) to a second contact area (132) of a power semiconductor module (200);
- the spring element (110) comprises a core (140) made from a first material and a conductive coating (142) made from a second material, the first material being different from the second material;
- the core (140) made from the first material has a higher elasticity than the conductive coating (142) made from the second material so as to provide a significant part of the spring force (F_{S}); and
- the conductive coating (142) made from the second material has a higher electrical conductivity than the core (140) made from the first material so as to carry a significant part of a current flowing between the first contact (116) and the second contact (118).

2. The spring element (110) of claim 1, wherein the first material has an elasticity being determined by a Young modulus of equal or more than 100 GPa.

3. The spring element (110) of claim 2, wherein the core (140) is made from spring steel or stainless steel having a thickness between 0.2 mm and 2.5 mm.

4. The spring element (110) of any one of claims 1 to 3, wherein the second material has an electric conductivity of equal or more than 5.0 x 10⁶ S/m.

5. The spring element (110) of claim 4, wherein at least one of the conductive coating (142) is made from copper, silver, gold or aluminum, and the conductive coating (142) has a thickness between 2 µm and 20 µm.

6. The spring element (110) of any one of claims 1 to 5, further comprising a deformation portion (124) for providing the spring force (F_{S}) to the first contact portion (126) and the second contact portion (128), wherein the first contact portion (126) is located opposite to the second contact portion (128) with regard to the deformation portion (124).

7. The spring element (110) of claim 6, wherein at least one of the deformation portion (124), the first contact portion (124) and the second contact portion (128) comprises a bent, elongated strip of metal.

8. The spring element (110) of claim 6 or 7, wherein the deformation portion (124) is point symmetric with regard to a central point (P) or mirror symmetric with regard to a central axis (A) arranged between the first contact (116) and the second contact (118).

9. The spring element (110) of any one of claims 6 to 8, wherein the deformation portion (124) is essentially S-shaped or C-shaped.

10. The spring element (110) of any one of claims 1 to 9, further comprising a protective coating (144) made from a third material and coating at least parts of the conductive coating (142), the third material being different than the second material.

11. A power semiconductor module (200), comprising at least one spring element (110) according to any of the preceding claims.

12. The power semiconductor module (200) according to claim 11, wherein the spring element (110) forms part of a control path for controlling the power semiconductor module (200).

13. The power semiconductor module (200) according to claim 12, wherein the spring element (110) has a predefined electrical resistivity and is configured to function as an external gate resistor in the control path.

14. A method for manufacturing a spring element (110) comprising a first contact portion (126), a second contact portion (128) and a deformation portion (124), comprising:
- providing a core (140) from a first material, and
- providing a conductive coating (142) from a second material on the core (140) to form a conductive path comprising at least one first contact (116) on the first contact portion and at least one second contact (118) on the second contact portion (128), the first material being different from the second material;
- forming the core (140) to create the deformation portion (124) for providing a spring force (F_{S}), wherein the first contact portion (126) is located on an opposite side of the second contact portion (128) with regard to the deformation portion (124);
- wherein the core (140) has a higher elasticity than the conductive coating (142) so as to provide a significant part of the spring force (F_{S}); and
- wherein the conductive coating (142) has a higher electrical conductivity than the core (140) so as to carry a significant part of a current flowing between the first contact (116) and the second contact (118).

15. A method for manufacturing a spring element (110) comprising a first contact portion (126), a second contact portion (128) and a deformation portion (124), comprising:
- providing a core (140) from a first material with a deformation portion (124) for providing a spring force (F_{S}), wherein the first contact portion (126) is located on an opposite side of the second contact portion (128) with regard to the deformation portion (124);
- forming a conductive coating (142) from a second material on the core (140) by coating the core (140) with the conductive coating (142) or electroplating the core (140) to form a conductive path comprising at least one first contact (116) on the first contact portion and at least one second contact (118) on the second contact portion (128), the first material being different from the second material;
- wherein the core (140) has a higher elasticity than the conductive coating (142) so as to provide a significant part of the spring force (F_{S}); and
- wherein the conductive coating (142) has a higher electrical conductivity than the core (140) so as to carry a significant part of a current flowing between the first contact (116) and the second contact (118).
